# EUROPEAN PATENT APPLICATION

(11) **EP 4 625 779 A1**
(43) Date of publication of application: **01.10.2025**
(21) Application number: 23910389.8
(22) Date of filing: 22.12.2023
(51) Int. Cl.: H02K 9/04, F25D 31/00, H02K 9/24, H02K 5/20

(54) **HEAT DISSIPATION DEVICE AND POWER GENERATION APPARATUS**

(30) Priority: 30.12.2022 CN 202223594216 U
(71) Applicant: Sungrow Power Supply Co., Ltd., Hefei, Anhui 230088 (CN)
(72) Inventor: FENG, Jigui, Hefei, Anhui 230088 (CN); LI, Yonghong, Hefei, Anhui 230088 (CN); ZHANG, Weifeng, Hefei, Anhui 230088 (CN)
(74) Representative: Rooney, John-Paul
(86) International application number: PCT/CN2023/140971
(87) International publication number: WO 2024/140463

(57) **Abstract**

A heat dissipation device and a power generation apparatus. The heat dissipation device comprises a box and a heat sink arranged in the box, wherein the box is provided with an air inlet and an air outlet; an airflow can enter an airflow inlet end of the heat sink through the air inlet, and then flows out from an airflow outlet end of the heat sink; and a first air guide plate assembly, which is detachably connected to the box, is provided in the box, and guides the airflow entering the box through the air inlet to enter the airflow outlet end and then flow out from the airflow inlet end. The first air guide plate assembly is inserted in the box, so that an air duct inside the box is changed, and the entering airflow can enter the heat sink in a direction opposite the direction in a heat dissipation mode, so as to purge foreign matter such as dust, which is accumulated and blocked in an internal heat dissipation air duct of the heat sink. When heat dissipation is required after cleaning, the first air guide plate assembly can be removed, thereby restoring an air duct in the heat dissipation mode.

## Description

This application claims the priority to Chinese Patent Application No. 202223594216.4, titled "HEAT DISSIPATION DEVICE AND POWER GENERATION APPARATUS", filed with the China National Intellectual Property Administration on December 30, 2022, the entire content of which is incorporated herein by reference.

### FIELD

The present application relates to the technical field of heat dissipation, and in particular, to a heat dissipation device and a power generation apparatus.

### BACKGROUND

Radiators are widely applied, including air-cooled radiators. An air-cooled radiator is provided with a heat dissipation air duct for airflow to pass through. When the radiator is mounted in an environment with much sand, many foreign objects or poplar fluffs, these external foreign objects may enter the heat dissipation air duct inside the radiator through an air inlet and accumulate in the heat dissipation air duct, thereby blocking the heat dissipation air duct and finally affecting the heat dissipation of the whole radiator.

### SUMMARY

A heat dissipation device is provided according to the present application, including a casing and a radiator provided in the casing. The casing is provided with an air inlet and an air outlet, and the heat dissipation device is configured to allow an airflow to enter an airflow inlet end of the radiator through the air inlet and exit through an airflow outlet end of the radiator. A first air guide plate assembly is provided in the casing and is detachably connected to the casing, and the first air guide plate assembly is configured to guide the airflow entering through the air inlet to enter through the airflow outlet end and exit through the airflow inlet end.

In a specific embodiment, the first air guide plate assembly includes a first air guide plate and a second air guide plate, the first air guide plate blocks a passage between the airflow inlet end and the air inlet, and the second air guide plate blocks a passage between the airflow outlet end and the air outlet. A gap exists between the first air guide plate and the airflow inlet end, and a gap exists between the second air guide plate and the airflow outlet end. The first air guide plate, a first side of the radiator, the casing, and the second air guide plate define an airflow channel.

In a specific embodiment, a radiator air baffle is provided on the first side of the radiator, and the first air guide plate, the radiator air baffle, the casing, and the second air guide plate define the airflow channel.

In a specific embodiment, the casing is provided with a first opening in communication with the outside, and the airflow channel is in communication with the first opening.

In a specific embodiment, the casing is further provided with a second opening, the first air guide plate is inserted into the casing through the first opening, and the second air guide plate is inserted into the casing through the second opening.

In a specific embodiment, a second air guide plate assembly is further provided in the casing and is detachably connected to the casing, the second air guide plate assembly includes a third air guide plate and a fourth air guide plate; the third air guide plate and the casing cooperate to define a first air duct, the first air duct is in communication with the air inlet and the airflow inlet end, the fourth air guide plate and the casing cooperate to define a second air duct, and the second air duct is in communication with the airflow outlet end and the air outlet; and
the third air guide plate is inserted into the casing through the first opening, and the fourth air guide plate is inserted into the casing through the second opening.

In a specific embodiment, a first guide rail and a second guide rail are provided on the first side of the radiator, a third guide rail and a fourth guide rail are provided on a wall plate of the casing facing the first side, and a fifth guide rail and a sixth guide rail are provided on a second side of the radiator opposite to the first side. The first air guide plate slides along the first guide rail and the fifth guide rail, and the second air guide plate slides along the sixth guide rail and the fourth guide rail. The third air guide plate slides along the third guide rail and the first guide rail, and the fourth air guide plate slides along the second guide rail and the fourth guide rail.

In a specific embodiment, an end of each of the second air guide plate, the third air guide plate and the fourth air guide plate is provided with an end plate, the end plate is located outside the casing and configured to be connected to the casing, and the end plate is provided with a handle.

In a specific embodiment, a second air guide plate assembly is further provided in the casing and is detachably connected to the casing. The second air guide plate assembly includes a third air guide plate and a fourth air guide plate, the third air guide plate and the casing cooperate to define a first air duct, the first air duct is in communication with the air inlet and the airflow inlet end. The fourth air guide plate and the casing cooperate to define a second air duct, and the second air duct is in communication with the airflow outlet end and the air outlet.

A power generation apparatus is further provided according to the present application, including a generator and the heat dissipation device described above, where the generator is arranged in the casing.

According to the present application, the first air guide plate assembly is inserted into the casing, so that the internal air duct is changed, and the entering airflow can enter the radiator in a direction opposite to the flow direction in the heat dissipation mode, so as to blow foreign matters such as dust accumulated and blocked in the heat dissipation air duct inside the radiator. When heat dissipation is required after cleaning, the first air guide plate assembly may be taken out to restore to an air duct for the heat dissipation mode.

### BRIEF DESCRIPTION OF THE DRAWINGS

FIG. 1 is a schematic view of a heat dissipation device according to an embodiment of the present application;
FIG. 2 is a cross-sectional view taken along A-A direction in FIG. 1;
FIG. 3 shows that a third air guide plate and a fourth air guide plate of a second air guide plate assembly in FIG. 1 are pulled out from a casing;
FIG. 4 is a schematic view of the third air guide plate in FIG. 3;
FIG. 5 is a schematic view of the fourth air guide plate in FIG. 3;
FIG. 6 is a schematic view of a radiator in FIG. 2;
FIG. 7 shows that a first air guide plate assembly is mounted into the casing after the second air guide plate assembly in FIG. 1 is pulled out of the casing;
FIG. 8 is a front view of FIG. 7;
FIG. 9 is a cross-sectional view taken along B-B direction in FIG. 8;
FIG. 10 is a schematic view of a first air guide plate in FIG. 7; and
FIG. 11 is a schematic view of a second air guide plate in FIG. 7.

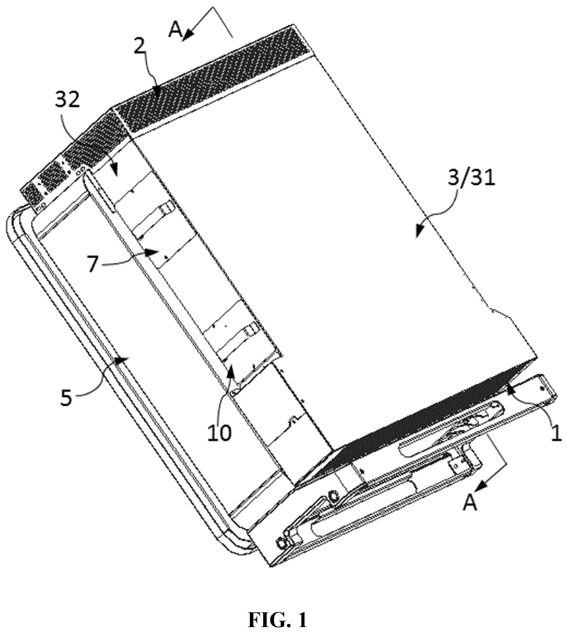

Reference numerals in FIG. 1 to FIG. 11 are listed as follows:

| | | | | | |
|---|---|---|---|---|---|
| 1. | air inlet; | 2. | air outlet; | 3. | rear cover plate; |
| 3a. | first opening; | 3b. | second opening; | 31. | wall plate; |
| 32. | side wall; | 4. | base; | 5. | front housing; |
| 51. | wall plate; | 6. | reactor; | 7. | fourth air guide plate; |
| 71. | handle; | 72. | end plate; | 8. | radiator air baffle; |
| 9. | radiator; | 9A. | airflow inlet end; | 9B. | airflow outlet end; |
| 10. | third air guide plate; | 101. | handle; | 102. | end plate; |
| 11. | fan; | 12. | second air guide plate; | 121. | handle; |
| 122. | end plate; | 13. | first air guide plate; | 131. | first flanging; |
| 132. | second flanging; | 133. | third flanging; | 13a. | port; |
| 14. | first guide rail; | 15. | second guide rail; | 16. | third guide rail; |
| 17. | fourth guide rail; | 18. | fifth guide rail; | 19. | sixth guide rail; |
| 20. | base plate; | 21. | guide rail plate. | | |

### DETAILED DESCRIPTION OF THE EMBODIMENTS

In order to enable those skilled in the art to better understand the solutions of the present application, the present application is further described in detail below with reference to the accompanying drawings and specific embodiments.

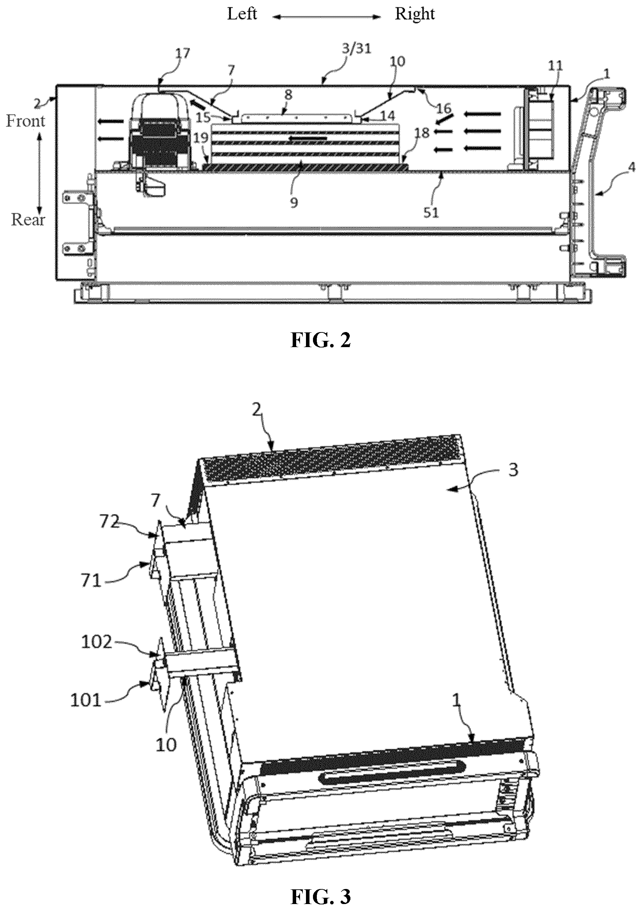

Referring to FIG. 1 and FIG. 2, FIG. 1 is a schematic view of a heat dissipation device according to an embodiment of the present application, and FIG. 2 is a cross-sectional view taken along A-A direction in FIG. 1.

In the embodiment, the heat dissipation device includes a casing and a radiator 9 arranged in the casing. The heat dissipation device is specifically a heat dissipation device for a power generation apparatus, and a generator (not shown in the figure) is also arranged in the casing. In FIG. 2, the casing is divided into an upper portion and a lower portion which are a front cavity and a rear cavity respectively. The rear cavity is located on a back side of the casing and is configured for accommodating the radiator 9, a reactor 6, a fan 11 and so on, and the front cavity is configured for accommodating the generator. A rear housing part of the casing corresponding to the rear cavity is specifically a rear cover plate 3, and the rear cover plate 3 is of a housing structure with a front opening and is engaged with a front housing 5 of the front cavity. That is, the casing includes the rear cover plate 3 and the front housing 5. Alternatively, the casing may be a casing divided into two parts by a partition plate. The structure of the casing is not specifically limited in the embodiment. In FIG. 2, a base 4 is arranged on a right side of the casing, and the base 4 is configured for supporting the casing or mounting the casing to an expected apparatus. In actual use, the base 4 may be located at a bottommost position, that is, the casing in FIG. 2 is rotated clockwise by 90 degrees for arrangement. The specific orientation of the casing is not specifically limited in the embodiment. In addition, in FIG. 2, the radiator 9 is mounted on a wall plate 51 of the front housing 5 and is spaced apart from a wall plate 31 of the rear cover plate 3, and the wall plate 51 of the front housing 5 and the wall plate 31 of the rear cover plate 3 are arranged opposite to each other along a front-rear direction.

As shown in FIG. 1, an air inlet 1 and an air outlet 2 are provided at a left end and a right end of the casing. An airflow can enter the casing through the air inlet 1, flow through the radiator 9 in a first direction, and then flow out of the casing through the air outlet 2. Mesh housings may be arranged at two ends of the casing to be used as the air inlet 1 and the air outlet 2. The radiator 9 is internally provided with an inner heat dissipation air channel through which the airflow passes, and two ends of the radiator 9 are respectively an airflow inlet end 9A and an airflow outlet end 9B. In FIG. 1, the inner heat dissipation air duct of the radiator 9 is a straight-line flow channel, and the first direction is a straight line direction from the airflow inlet end 9A to the airflow outlet end 9B. However, the first direction defined in the embodiment is not necessarily straight-line, and is just expected to be an orientation from the airflow inlet end 9A to the airflow outlet end 9B in a normal heat dissipation mode. The airflow inlet end 9A and the airflow outlet end 9B are named based on a flow direction in the normal heat dissipation mode.

It should be noted that, in the embodiment, a first air guide plate assembly detachably connected to the casing is provided in the casing. The first air guide plate assembly guides the airflow entering through the air inlet 1 to flow through the radiator 9 in a second direction opposite to the first direction, that is, the airflow enters through the airflow outlet end 9B and flows out through the airflow inlet end 9A. In this case, the first air guide plate assembly guides the airflow to flow reversely through the radiator 9, and this mode is a cleaning mode of the heat dissipation device.

In the embodiment, the heat dissipation device further includes a second air guide plate assembly detachably connected to the casing. The second air guide plate assembly includes a third air guide plate 10 and a fourth air guide plate 7, and the first air guide plate assembly includes a first air guide plate 13 and a second air guide plate 12. In the heat dissipation mode, the second air guide plate assembly is mounted in the casing. In the cleaning mode, the second air guide plate assembly may be replaced and removed, and the first air guide plate assembly is mounted in the casing.

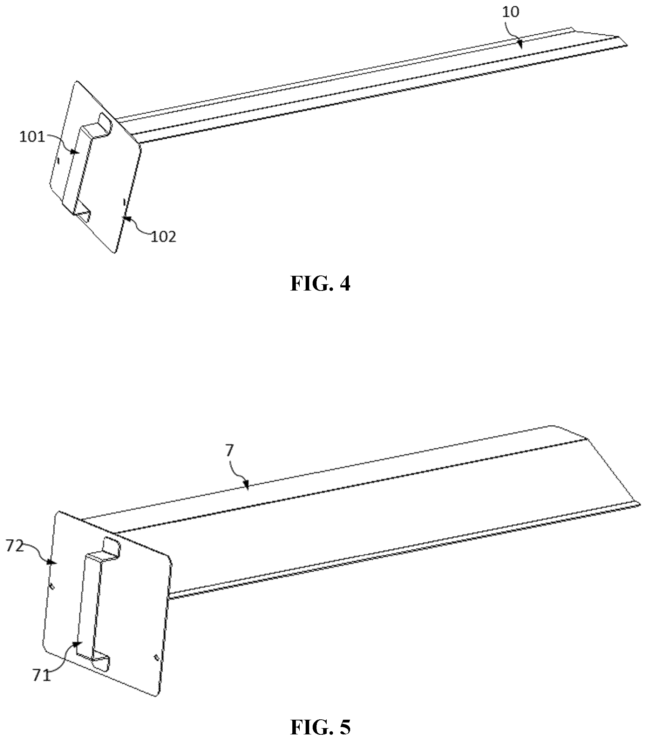

Specifically, with reference to FIG. 3 to FIG. 5, FIG. 3 shows that the third air guide plate 10 and the fourth air guide plate 7 of the second air guide plate assembly in FIG. 1 are pulled out from the casing, FIG. 4 is a schematic view of the third air guide plate 10 in FIG. 3, and FIG. 5 is a schematic view of the fourth air guide plate 7 in FIG. 3.

In the normal heat dissipation mode, the second air guide plate assembly is arranged in the casing. As shown in FIG. 2, the third air guide plate 10 and the casing cooperate to define a first air channel, and specifically, the third air guide plate 10, the wall plate 31 of the rear cover plate 3 of the casing and the wall plate 51 of the front housing 5 together define the first air channel. The first air channel is in communication with the air inlet 1 which is specifically arranged at a right side wall of the rear cover plate 3. A fan 11 is arranged between the air inlet 1 and the radiator 9. One side of the third air guide plate 10 is connected to the wall plate 31 of the rear cover plate 3, and the other side of the third air guide plate 10 is connected to a first side of the radiator 9. The first side of the radiator 9 is a rear side of the radiator 9, and a second side of the radiator 9 is a front side of the radiator 9. In this way, the third air guide plate 10 prevents the airflow from flowing out of a gap between the radiator 9 and the rear cover plate 3, and the airflow entering through the air inlet 1 can only flow to the airflow inlet end 9A of the radiator 9 through the first air duct.

The fourth air guide plate 7 cooperates with the casing to define a second air duct, and specifically, the fourth air guide plate 7, the wall plate 31 of the rear cover plate 3 of the casing and the wall plate 51 of the front housing 5 together define the second air duct. The second air duct is in communication with the airflow outlet end 9B of the radiator 9 and the air outlet 2. The air inlet 1 is specifically arranged at a left side wall of the rear cover plate 3, and a reactor 6 may be arranged between the air outlet 2 and the radiator 9. One side of the fourth air guide plate 7 is connected to the wall plate 31 of the rear cover plate 3, and the other side of the fourth air guide plate 7 is connected to the first side of the radiator 9. In this way, the fourth air guide plate 7 can prevent the airflow flowing out of the airflow outlet end 9B from flowing back through the gap between the radiator 9 and the rear cover plate 3, and the airflow flowing out of the airflow outlet end 9B directly flows out of the air outlet 2 through the second air duct.

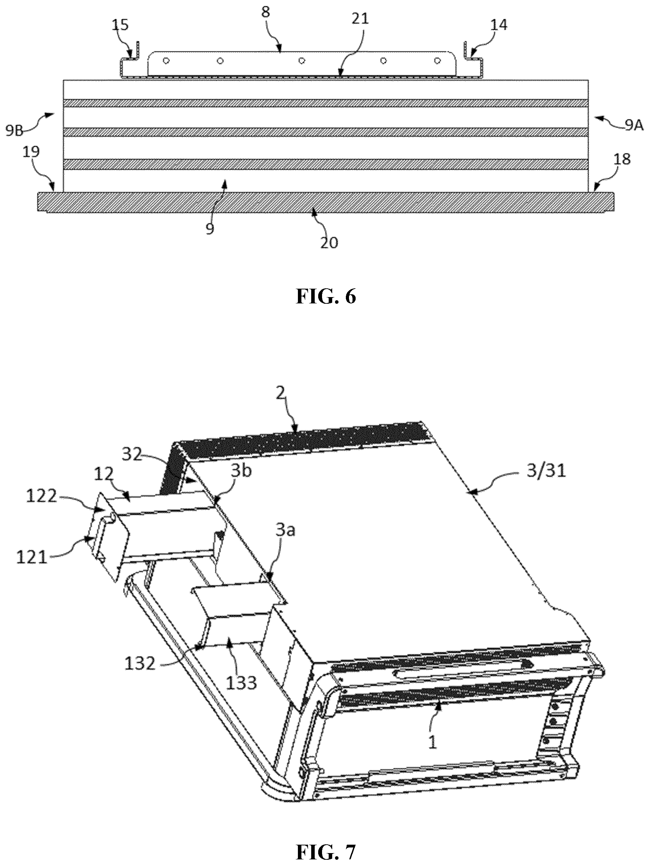

With reference to FIG. 6, FIG. 6 is a schematic view of the radiator 9 in FIG. 2.

The first side of the radiator 9 facing the rear cover plate 3 is provided with a radiator air baffle 8, and the second side of the radiator 9 facing away from the rear cover plate 3 is provided with a base plate 20. The radiator 9 may be fixed to the wall plate 51 of the front housing 5 through the base plate 20. A guide rail plate 21 is arranged between the radiator air baffle 8 and the first side of the radiator 9. One side of the guide rail plate 21 close to the airflow inlet end 9A of the radiator 9 is bent backward, leftward and backward to form a first guide rail 14, that is, the first guide rail 14 is Z-shaped. One side of the guide rail plate 21 close to the airflow outlet end 9B is bent backward, rightward and backward to form a second guide rail 15, that is, the second guide rail 15 is Z-shaped. Referring to FIG. 2 again, a third guide rail 16 and a fourth guide rail 17 are arranged on an inner side of the wall plate 31 of the rear cover plate 3, and the third guide rail 16 and the fourth guide rail 17 are also Z-shaped, where the Z shape is the cross-sectional shape of each guide rail.

Referring to FIG. 2, FIG. 4 and FIG. 5, one side edge of the third air guide plate 10 is lapped on the first guide rail 14, and the other side edge is lapped on the third guide rail 16. One side edge of the fourth air guide plate 7 is lapped on the fourth guide rail 17, and the other side edge is lapped on the second guide rail 15. A first opening 3a and a second opening 3b are formed in a side wall 32 of the rear cover plate 3. and the third air guide plate 10 and the fourth air guide plate 7 can slide into the casing through the first opening 3a and the second opening 3b respectively, along extension directions of the first guide rail 14, the second guide rail 15, the third guide rail 16 and the fourth guide rail 17, so as to realize detachable connection. As shown in FIG. 3, the third air guide plate 10 and the fourth air guide plate 7 are slidably mounted in the casing, and their insertion or withdrawal direction is perpendicular to the front-rear direction. This mounting manner is relatively simple and easy to assemble and disassemble. However, it should be understood that the third air guide plate 10 and the fourth air guide plate 7 may be detachably connected to the casing in other manners. For example, the rear cover plate 3 is provided with corresponding snap-fit structures, and the third air guide plate 10 and the fourth air guide plate 7 may be engaged with the snap-fit structures after being inserted into the casing. The connection manner of the first air guide plate assembly described below is similar to that of the second air guide plate assembly.

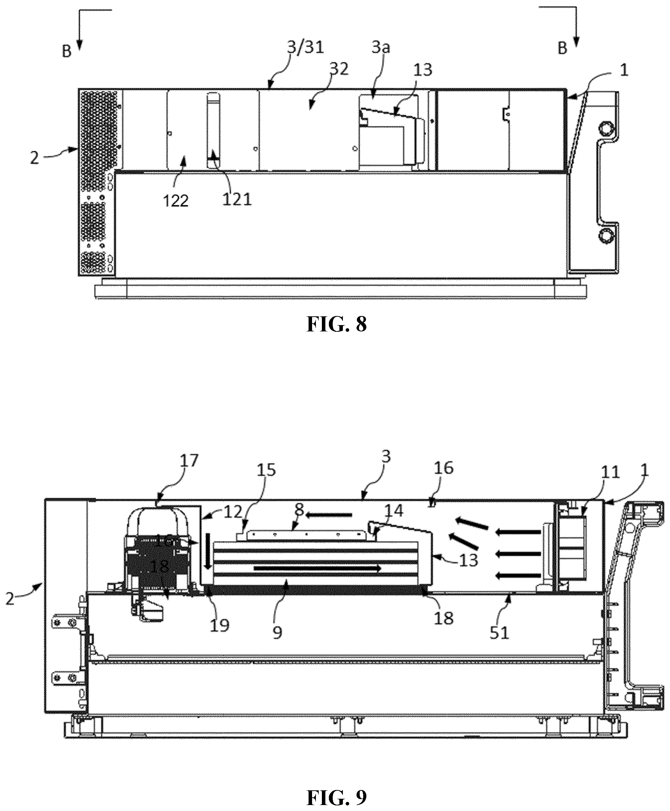

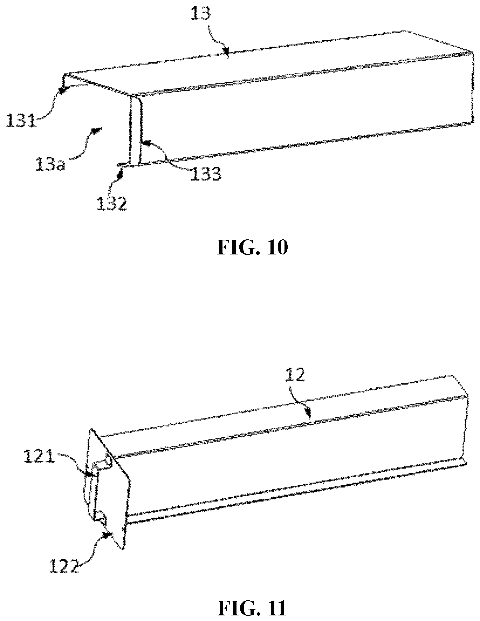

Referring to FIG. 7 to FIG. 11, FIG. 7 shows that the first air guide plate assembly is mounted into the casing after the second air guide plate assembly in FIG. 1 is pulled out of the casing, FIG. 8 is a front view of FIG. 7, FIG. 9 is a cross-sectional view of FIG. 7, FIG. 10 is a schematic view of the first air guide plate 13 in FIG. 7, and FIG. 11 is a schematic view of the second air guide plate 12 in FIG. 7.

In the cleaning mode, the first air guide plate assembly is removed from the casing and the second air guide plate assembly is mounted in the casing.

As shown in FIG. 7, similar to assembly and disassembly of the second air guide plate assembly, in the embodiment, the first air guide plate 13 and the second air guide plate 12 of the first air guide plate assembly are also slidably mounted to the casing. Specifically, the first air guide plate 13 is inserted into or withdrawn through the first opening 3a, and the second air guide plate 12 is inserted into or withdrawn through the second opening 3b. Part of the first air guide plate 13 is located at the airflow inlet end 9A of the radiator 9 to block the airflow inlet end 9A, and there is a gap between the first air guide plate 13 and the airflow inlet end 9A, so as to block a passage between the airflow inlet end 9A and the air inlet 1. The second air guide plate 12 blocks a passage between the airflow outlet end 9B of the radiator 9 and the air outlet 2, and there is a gap between the second air guide plate 12 and the airflow outlet end 9B. The first air guide plate 13, the first side of the radiator 9, the casing and the second air guide plate 12 together define an airflow channel.

As shown in FIG. 9, one side of the first air guide plate 13 is attached to an uppermost side plate of the first guide rail 14 and can slide along the first guide rail 14. The first air guide plate 13 is attached to a left side of the uppermost side plate of the first guide rail 14, that is, the position where the first air guide plate 13 is engaged with the first guide rail 14 is different from the position where the third air guide plate 10 is engaged with the first guide rail 14. The engagement between the first air guide plate 13 and the first guide rail 14 is favorable for blocking the passage between the airflow inlet end 9A and the air inlet 1. With reference to FIG. 6, a left side and a right side of the base plate 20 extend out from the radiator 9, and the extended portions form a fifth guide rail 18 and a sixth guide rail 19 respectively. The other side of the first air guide plate 13 is supported on the fifth guide rail 18 of the base plate 20. One side of the second air guide plate 12 is lapped on the fourth guide rail 17 in the same way as the connection between the fourth air guide plate 7 and the fourth guide rail 17, and the other side of the second air guide plate 12 is lapped on the sixth guide rail 19 of the base plate 20.

In this case, the airflow can only flow through the channel defined by the first air guide plate 13, the radiator air baffle 8 and the wall plate 31 of the rear cover plate 3. During the process of the airflow flowing towards the air outlet 2, the airflow is blocked by the second air guide plate 12, so that the airflow can only flow into the space between the second air guide plate 12 and the airflow outlet end 9B of the radiator 9, and then enter the radiator 9 and flow in the radiator 9 along the second direction opposite to the flow direction in the heat dissipation mode, and finally flow to the first air guide plate 13. Due to the blocking of the first air guide plate 13, the airflow does not flow back to the space between the fan 11 and the first air guide plate 13. A passage communicated with the space between the first air guide plate 13 and the radiator 9 may be formed in the casing to guide the airflow out of the casing. Specifically, the airflow may flow out directly through the first opening 3a through which the first air guide plate 13 is mounted into the casing. As shown in FIG. 8 and FIG. 10, the first opening 3a corresponds to a port 13a of the first air guide plate 13, and the airflow flows out through the port 13a and the first opening 3a. In this way, foreign matters such as dust brought out by the airflow during the cleaning process can be discharged to the outside of the casing to achieve a good cleaning effect. Another passage may be provided to communicate with the outside. In this case, the first opening 3a for assembly and disassembly is used as an air vent, so the structure is simple.

In the embodiment, the first air guide plate 13 is substantially L-shaped and is provided with a first flanging 131, a second flanging 132 and a third flanging 133. The first flanging 131 slides along the first guide rail 14, the second flanging 132 slides along the fifth guide rail 18, and the third flanging 133 may be engaged with the side wall 32 of the rear cover plate 3 at the position of the first opening 3a, so as to play a limiting role. It should be noted that the second flanging 132 extends toward the radiator 9. Foreign matters such as dust are blown out through the airflow inlet end 9A of the radiator 9, and then the foreign matters may be accumulated on the second flanging 132, which is convenient for blowing out the foreign matters. Moreover, even if the foreign matters are not blown out, the accumulated foreign matters can be cleaned when the first air guide plate 13 is taken out. The first air guide plate 13 may be provided with an end plate 132 and a handle 131, which have the same function as the arrangement of the second air guide plate 13, so as to facilitate pushing in or pulling out the first air guide plate 13.

The second air guide plate 12 is substantially Z-shaped, including a first plate portion, a second plate portion and a vertical portion connecting the first plate portion and the second plate portion, and the first plate portion and the second plate portion are substantially parallel and staggered. The first plate portion is lapped on the fourth guide rail 17, the second plate portion is supported on the sixth guide rail 19, and the vertical portion is configured for blocking the airflow. An end plate 122 is provided at an end of the second air guide plate 12, and may be engaged with the side wall 32 of the rear cover plate 3 at the position of the second opening 3b, so as to play a limiting role. The end plate 122 can also block the second opening 3b to ensure that the airflow enters the radiator 9 through the airflow outlet end 9B of the radiator 9. The end plate 122 may also be provided with a connecting hole, so as to be connected and fixed to the side wall 32 of the rear cover plate 3 by a connecting member inserted into the connecting hole, so that the structure is stable during operation. The connecting member may be a connecting screw, a pin and the like. A handle 121 may be provided on the end plate 122 to facilitate pushing in or pulling out the second air guide plate 12. Similarly, the third air guide plate 10 is provided with an end plate 102 and a handle 101, the fourth air guide plate 7 is provided with an end plate 72 and a handle 71, and each of the end plate 102 and the end plate 72 is provided with a connecting hole.

It can be seen that, in the embodiment, the first air guide plate assembly is inserted into the casing, so that the internal air duct is changed, and the entering airflow can enter the radiator 9 in a direction opposite to the flow direction in the heat dissipation mode, so as to blow away foreign matters such as dust blocked in the heat dissipation air duct inside the radiator 9. When heat dissipation is needed after cleaning, the first air guide plate assembly can be taken out to restore to the air duct for the heat dissipation mode.

Based on this, the specific structures of the first air guide plate assembly and the second air guide plate assembly are merely specific examples, and obviously are not limited thereto. For example, each of the first air guide plate assembly and the second air guide plate assembly may include more air guide plates or only be provided with one air guide plate, as long as the corresponding wall surface of the casing, the radiator 9, or other structures inside the casing can cooperate to define an air duct with the expected direction. In fact, the second air guide plate assembly may not be provided in the casing, and the interior of the casing itself forms an expected heat dissipation air duct which is used in the heat dissipation mode, and part of the heat dissipation air distribution duct is blocked after inserting the first air guide plate assembly, so as to force the airflow to flow along an air duct path for cleaning.

In addition, in the embodiment, the heat dissipation device is described based on the example where the heat dissipation device is provided in the power generation apparatus. Apparently, the heat dissipation device is not limited to being applied to the power generation apparatus, and any apparatus that needs heat dissipation may be provided with the heat dissipation device according to the embodiment.

The principle and implementation of the present application are described herein with reference to specific embodiments, and the description of the above embodiments are only used to help understand the method and core idea of the present application. It should be noted that for those skilled in the art, several improvements and modifications may be made to the present application without departing from the principle of the present application, and these improvements and modifications will also fall within the protection scope of the claims of the present application.

## Claims

1. A heat dissipation device, comprising a casing and a radiator provided in the casing, wherein
the casing is provided with an air inlet and an air outlet, and the heat dissipation device is configured to allow an airflow to enter an airflow inlet end of the radiator through the air inlet and exit through an airflow outlet end of the radiator; and
a first air guide plate assembly is provided in the casing and is detachably connected to the casing, and the first air guide plate assembly is configured to guide the airflow entering through the air inlet to enter through the airflow outlet end and exit through the airflow inlet end.

2. The heat dissipation device according to claim 1, wherein
the first air guide plate assembly comprises a first air guide plate and a second air guide plate, the first air guide plate blocks a passage between the airflow inlet end and the air inlet, and the second air guide plate blocks a passage between the airflow outlet end and the air outlet;
a gap exists between the first air guide plate and the airflow inlet end, and a gap exists between the second air guide plate and the airflow outlet end; and
the first air guide plate, the radiator, the casing, and the second air guide plate define an airflow channel.

3. The heat dissipation device according to claim 2, wherein the radiator is provided with a radiator air baffle, and the first air guide plate, the radiator air baffle, the casing and the second air guide plate define the airflow channel.

4. The heat dissipation device according to claim 2, wherein the casing is provided with a first opening in communication with the outside, and the airflow channel is in communication with the first opening.

5. The heat dissipation device according to claim 4, wherein the casing is further provided with a second opening, the first air guide plate is inserted into the casing through the first opening, and the second air guide plate is inserted into the casing through the second opening.

6. The heat dissipation device according to claim 5, wherein the second air guide plate comprises an end plate which is configured to block the second opening, and the first opening is still in communication with the outside after the first air guide plate is inserted into the first opening.

7. The heat dissipation device according to claim 5, wherein
a second air guide plate assembly is further provided in the casing and is detachably connected to the casing, and the second air guide plate assembly comprises a third air guide plate and a fourth air guide plate;
the third air guide plate and the casing cooperate to define a first air duct, the first air duct is in communication with the air inlet and the airflow inlet end, the fourth air guide plate and the casing cooperate to define a second air duct, and the second air duct is in communication with the airflow outlet end and the air outlet; and
the third air guide plate is inserted into the casing through the first opening, and the fourth air guide plate is inserted into the casing through the second opening.

8. The heat dissipation device according to claim 7, wherein
a first guide rail and a second guide rail are provided on a first side of the radiator, a third guide rail and a fourth guide rail are provided on a wall plate of the casing that faces the first side, a fifth guide rail and a sixth guide rail are provided on a second side of the radiator opposite to the first side; and
the first air guide plate is configured to slide along the first guide rail and the fifth guide rail, the second air guide plate is configured to slide along the sixth guide rail and the fourth guide rail, the third air guide plate is configured to slide along the third guide rail and the first guide rail, and the fourth air guide plate is configured to slide along the second guide rail and the fourth guide rail.

9. The heat dissipation device according to claim 7, wherein an end of each of the second air guide plate, the third air guide plate and the fourth air guide plate is provided with an end plate, the end plate is located outside the casing and is configured to be connected to the casing, and the end plate is provided with a handle.

10. The heat dissipation device according to any one of claims 1 to 6, wherein
a second air guide plate assembly is further provided in the casing and is detachably connected to the casing, and the second air guide plate assembly comprises a third air guide plate and a fourth air guide plate; and
the third air guide plate and the casing cooperate to define a first air duct, the first air duct is in communication with the air inlet and the airflow inlet end, the fourth air guide plate and the casing cooperate to define a second air duct, and the second air duct is in communication with the airflow outlet end and the air outlet.

11. A power generation apparatus, comprising a generator and the heat dissipation device according to any one of claims 1 to 10, wherein the generator is arranged in the casing.
